# FASCICULE DE BREVET EUROPEEN

(11) **EP 0 437 409 B1**
(45) Date de publication et mention de la délivrance du brevet: **27.09.1995**
(21) Numéro de dépôt: 91420003.5
(22) Date de dépôt: 07.01.1991
(51) Int. Cl.: H03K 17/06

(54) **Commande et contrôle d'un commutateur de puissance**
Betätigung und Steuerung eines Leistungsschalters
Operation and control of a power switch

(30) Priorité: 09.01.1990 FR 9000404
(43) Date de publication de la demande: 17.07.1991
(73) Titulaire: SGS-THOMSON MICROELECTRONICS S.A., 94250 Gentilly (FR)
(72) Inventeur: Bourgeois, Jean-Marie, F-13830 La Bedoule (FR); Bildgen, Marco, F-13090 Aix en Provence (FR)
(74) Mandataire: de Beaumont, Michel

(56) Documents cités:
- EP-A- 0 268 930
- EP-A- 0 330 628

## Description

La présente invention concerne la commande et le contrôle des commutateurs de puissance. Elle concerne plus particulièrement la commande de commutateurs de puissance dont une borne se trouve à un potentiel de référence flottant et les circuits translateurs de niveau destinés à transmettre, à partir d'un circuit de contrôle à un potentiel de référence fixe, des ordres vers un circuit de commande de commutateur de puissance, ou inversement à en recevoir des informations de contrôle.

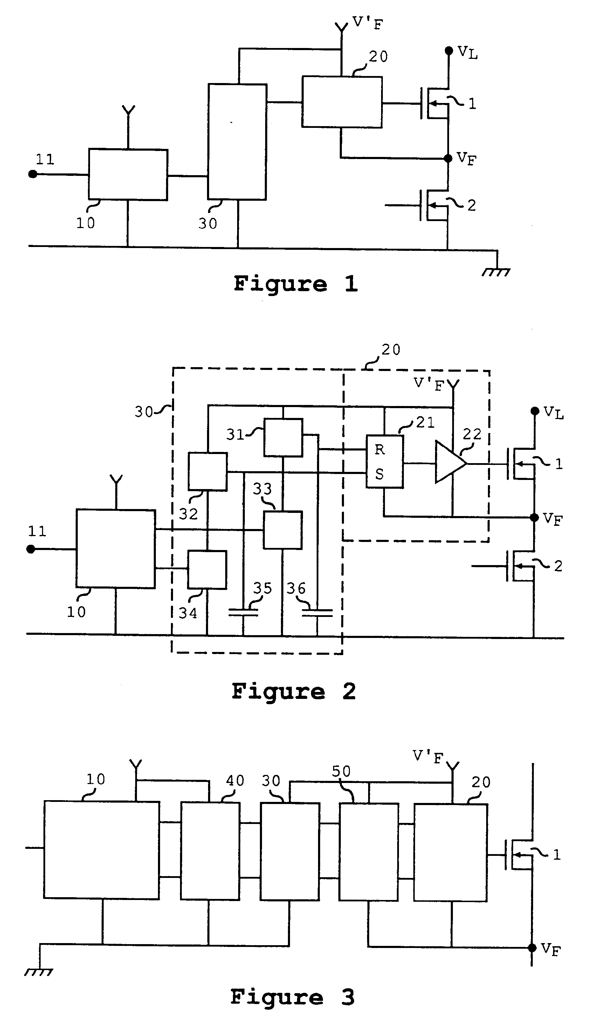

La figure 1 représente très schématiquement la commande d'un commutateur de puissance 1 disposé en série avec un autre commutateur de puissance 2 référencé à la masse, ces deux commutateurs faisant par exemple partie d'un montage en pont. Le point de connexion des deux commutateurs se trouve à un potentiel flottant V_{F} susceptible d'une part d'atteindre de fortes tensions, d'autre part d'être soumis à des variations de tension très rapides, par exemple plusieurs dizaines de milliers de volts par microseconde. L'ensemble de commande comprend, d'une part, un circuit de contrôle 10 recevant des ordres externes sur une borne 11 et référencé à la masse et d'autre part un circuit de commande de grille propre à chacun des commutateurs, et notamment un circuit de commande de grille 20 pour le commutateur 1. Entre les circuits 10 et 20 est inséré un circuit translateur de niveau 30 référencé à la masse ainsi qu'à un potentiel flottant V′_{F} variant avec le potentiel flottant V_{F}.

Le circuit de commande de grille 20 est nécessairement référencé au potentiel flottant V_{F}. Il se pose donc des problèmes de translation de niveau entre les circuits de contrôle et de commande et il se présente généralement deux inconvénients, d'une part, une certaine consommation d'énergie, quand le commutateur 1 est à l'état passant, due au courant circulant alors dans le translateur 30 soumis à la tension V′_{F}, d'autre part, une sensibilité aux parasites résultant des fluctuations du potentiel flottant V_{F} et donc de V′_{F}.

Pour résoudre les problèmes de consommation, on a prévu des circuits à commande par impulsions tels que celui illustré en figure 2. Dans ce circuit, la partie de commande de grille 20 comprend une bascule RS 21 dont la sortie est appliquée par un amplificateur 22 à la grille du transistor de puissance 1. Chacune des entrées R et S de la bascule reçoit l'une des sorties d'un circuit translateur de niveau, respectivement 31 et 32. L'ensemble de ces circuits 21, 22, 31 et 32 est référencé au potentiel flottant V′_{F}. Les circuits translateurs de niveau 31 et 32 reçoivent des impulsions de commande à partir du circuit de contrôle 10 par l'intermédiaire de circuits 33 et 34.

Ce type de circuit présente l'avantage d'éviter une dissipation notable d'énergie dans le circuit translateur 30 mais est sensible à des parasites sur la source V_{L} ou à des variations brutales de la tension V_{F}. En effet, il existe inévitablement des capacités parasites, par exemple des capacités de transistors MOS, 35 et 36, susceptibles de se charger sous l'effet de variations brutales de tension et susceptibles, par suite de variations brutales de la valeur du potentiel flottant, de faire apparaître des impulsions parasites aux bornes ou à l'intérieur des circuits 31 et 32 ce qui peut provoquer des basculements intempestifs de la bascule RS 21.

Un objet de la présente invention est de prévoir un circuit permettant d'éviter l'influence de ces capacités parasites.

Alors que l'approche usuelle pour atteindre ce résultat consiste à minimiser les valeurs des capacités parasites, la demanderesse s'est aperçu qu'un effort dans cette direction se heurte forcément à des limitations et la présente invention propose de transmettre les ordres, entre le circuit de contrôle référencé à la masse et le circuit de commande de grille référencé au potentiel flottant, par l'intermédiaire d'un ensemble de codage/translateur/décodage destiné à fournir des signaux d'actionnement codés de façon à l'une ou l'autre voie de la bascule RS seulement quand l'une des voies reçoit un signal codé prédéterminé.

Plus particulièrement, la présente invention concerne un circuit de commande et de contrôle d'un commutateur de puissance comprenant une première partie liée à ce commutateur et alimentée en référence au potentiel flottant d'une électrode de ce commutateur, une deuxième partie liée à des circuits extérieurs au commutateur et alimentée en référence à un potentiel fixe, un codeur au niveau de la deuxième partie et un décodeur adapté au niveau de la première partie. La liaison entre les deux parties se fait par deux voies respectivement reliées aux entrées R et S d'une bascule, et le codeur comprend des moyens pour envoyer simultanément au moins une impulsion sur chaque voie puis au moins une impulsion sur une voie sélectionnée, le décodeur comprenant des moyens de décodage appropriés.

Selon un mode de réalisation de la présente invention, les première et deuxième parties comprennent chacune un codeur/décodeur.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 et 2, décrites précédemment, sont destinées à illustrer l'état de la technique et le problème que vise à résoudre la présente invention ;
la figure 3 représente sous forme de blocs l'agencement général d'un circuit selon la présente invention ;
la figure 4 représente un mode de réalisation de circuit de codage selon la présente invention ;
la figure 5 représente un mode de réalisation de circuit de décodage selon la présente invention ;
la figure 6 représente des signaux en divers points du circuit de codage lors d'une commande de mise en conduction ; et
la figure 7 représente des signaux en divers points du circuit de codage lors d'une commande d'ouverture.

Dans ces diverses figures, de mêmes références numériques désignent des éléments identiques ou analogues.

La figure 3 illustre de façon générale et sous forme de blocs un circuit selon la présente invention. Ce circuit comprend, du côté du circuit de contrôle 10 référencé à la masse, un codeur d'impulsions 40 et, du côté du circuit de commande de grille 20 référencé au potentiel flottant V_{F}, un décodeur 50 séparés par un circuit translateur de niveau 30. Le décodeur a été illustré à l'entrée du circuit 20. En fait, il sera imbriqué avec ce circuit pour être disposé derrière les emplacements où sont susceptibles d'apparaître des impulsions parasites pour pouvoir faire la différence entre les impulsions codées en provenance du codeur 40 et des impulsions parasites, comme cela apparaîtra plus clairement à la lecture de la description ci-après.

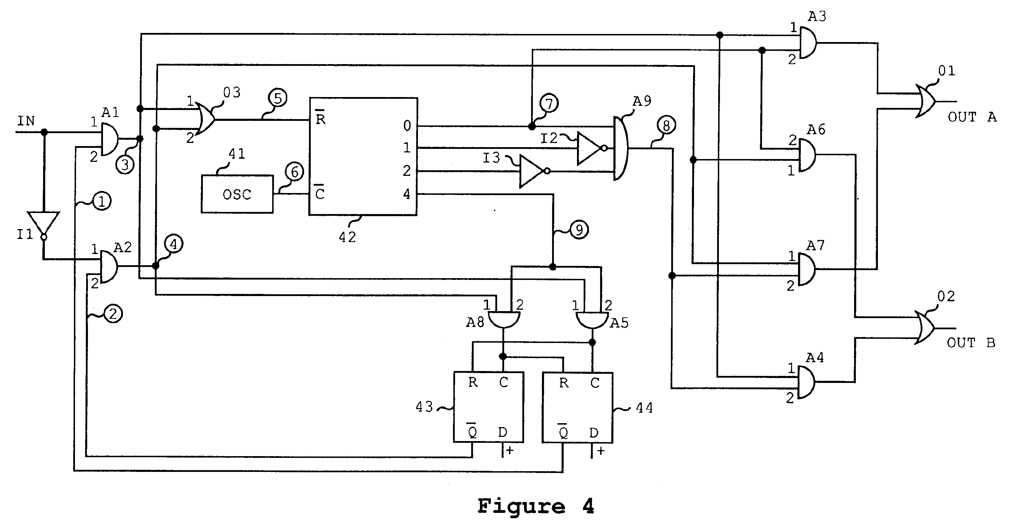

Un exemple de circuit codeur 40 faisant partie du circuit de contrôle 10 est illustré en figure 4. Ce circuit 40 comprend un oscillateur générateur d'impulsions 41 dont la sortie est appliquée à l'entrée C* d'un compteur 42. Le signal de commande déterminant la sortie de circuit apparaît sur son entrée IN et passe d'un état bas à un état haut quand on veut déterminer la mise en conduction du commutateur de puissance 1. Les sorties OUTA et OUTB de ce circuit apparaissent à la sortie de portes OU O1 et O2. Le signal IN est appliqué à l'entrée d'une porte ET A1 et, par l'intermédiaire d'un inverseur I1, à l'entrée d'une porte ET A2. La sortie de la porte A1 est envoyée à une première entrée d'une porte OU O3, d'une porte ET A3, d'une porte ET A4 et d'une porte ET A5. La sortie de la porte ET A2 est envoyée à la deuxième entrée de la porte OU O3, et aux premières entrées de portes ET A6, A7 et A8.

La sortie de la porte ET A5 est envoyée à l'entrée R d'une bascule de type D 43 et à l'entrée C d'une bascule de type D 44. La sortie de la porte ET A8 est envoyée à l'entrée C de la bascule 43 et à l'entrée R de la bascule 44. Les entrées D de ces bascules 43 et 44 sont fixées à un potentiel positif et les sorties complémentaires Q* de ces bascules sont respectivement envoyées à chacune des deuxièmes entrées des portes ET A1 et A2. La sortie de la porte OU O3 est envoyée à l'entrée R* du compteur 42. La sortie de rang 0 de ce compteur 42 est envoyée à une première entrée d'une porte ET à trois entrées A9 dont les deuxième et troisième entrées reçoivent les sorties de rang 1 et 2 du compteur 42 par l'intermédiaire d'inverseurs I2 et I3. La quatrième sortie du compteur 42 est envoyée aux deuxièmes entrées des portes A5 et A8. La sortie de rang 0 du compteur 42 est également envoyée aux deuxièmes entrées des portes A3 et A6. La sortie de la porte A9 est envoyée aux deuxièmes entrées des portes A4 et A7. La porte O1 reçoit les sorties des portes A3 et A7 et la porte O2 la sortie des portes A4 et A6.

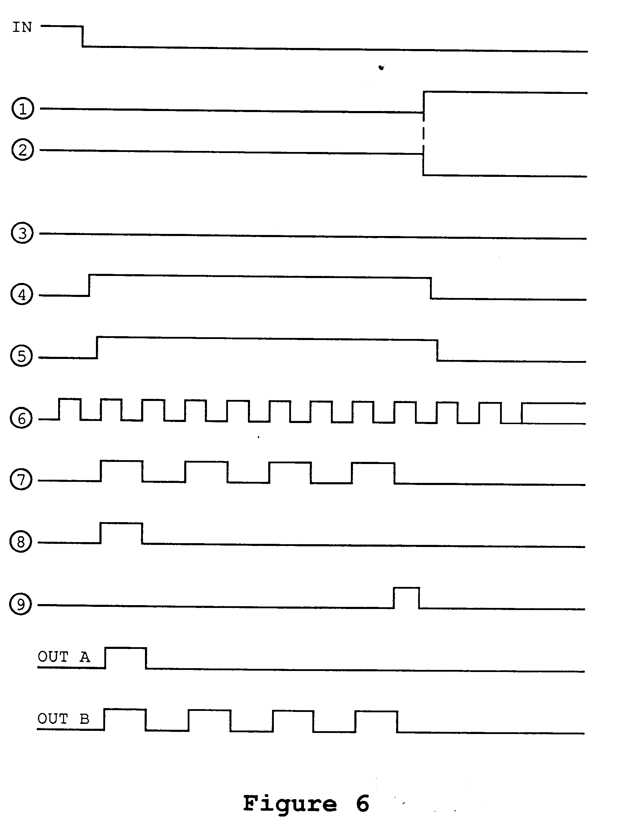

Le fonctionnement de ce circuit va être expliqué dans le cas d'une commande de mise en conduction du commutateur de puissance 1. Pour cela, on a indiqué en figure 6 le signal IN, qui passe d'un niveau bas à un niveau haut lors de la réception d'un ordre de fermeture et les signaux de sortie codés OUTA et OUTB résultants, ainsi que, par des chiffres entourés de cercles, les signaux apparaîssant en différents points du circuit désignés de la même manière.

On suppose qu'initialement la sortie Q* de la bascule 44 (1) est à haut niveau et la sortie Q* de la bascule 43 (2) est à bas niveau. Lors de la commutation de l'entrée IN, il en résulte que la sortie (3) de la porte ET A1 passe à haut niveau et que la sortie (4) de la porte ET A2 reste à bas niveau. La sortie (5) de la porte O3 passe également à haut niveau en même temps que la sortie (3) de la porte ET A1. La sortie (6) de l'oscillateur 41 fournit en continu des créneaux. Le signal (7) sur la sortie de comptage 0 du compteur 42 fournit des créneaux à fréquence moitié de celle l'oscillateur 41. La sortie (8) de la porte ET A9 fournit seulement le premier créneau et le signal (9) de sortie de comptage 4 du compteur 42 fournit une impulsion quand quatre créneaux ont été obtenus sur la sortie de comptage 0 (7). Ce signal (9) appliqué aux portes A5 et A8 fait changer d'état les signaux (1) et (2) (aux sorties Q* des bascules de type D 44 et 43). Il en résulte une commutation de l'état de la sortie (3) de la porte ET A1 et donc de la sortie (5) de la porte OU O3 et une inhibition du compteur 42. On voit que la sortie OUTA de la porte O1 correspond au signal (7) et que la sortie OUTB de la porte O2 correspond au signal (8). On obtient donc finalement à la sortie du circuit un signal OUTA constitué de quatre impulsions successives et un signal OUTB constitué d'une seule impulsion en coïncidence avec la première impulsion sur la sortie OUTA.

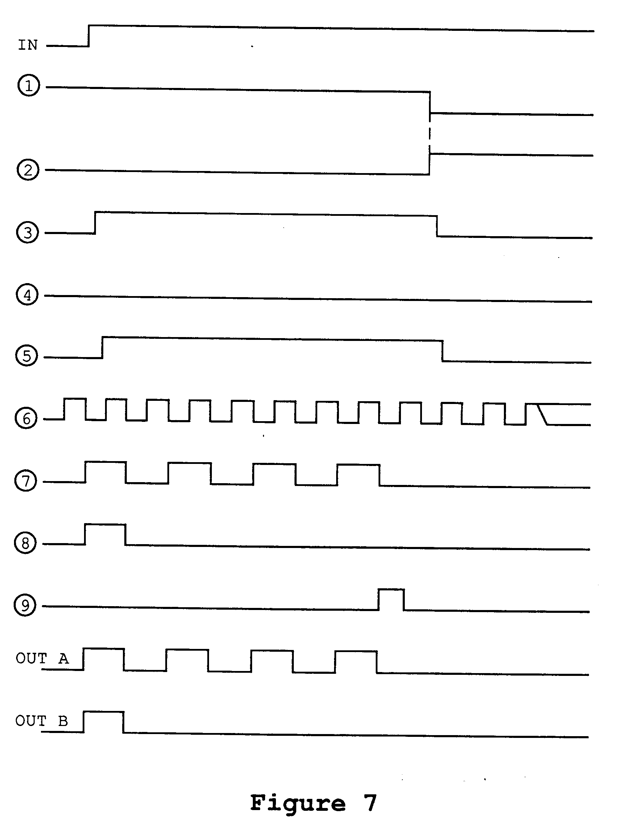

La figure 7 représente de façon correspondante les signaux apparaissant à l'entrée IN, aux points (1) à (9) et sur les sorties OUTA et OUTB quand le signal IN passe de haut à bas niveau pour déterminer l'ouverture de commutateur de puissance 1. Cette figure se comprend d'elle-même après la description détaillée faite précédemment de la figure 6. La figure 7 montre qu'un ordre d'ouverture correspondra à l'émission sur la sortie OUTA d'une impulsion et sur la sortie OUTB d'une succession de quatre impulsions dont la première est en coïncidence avec l'impulsion sur la sortie OUTA.

L'homme de l'art notera qu'il existe de très nombreuses façons de réaliser des circuits logiques fournissant des signaux de sortie tels que ceux désignés par OUTA et OUTB.

Toutefois, le choix du type de signaux de commande fournis à la sortie du circuit codeur 40 constitue l'un des aspects de la présente invention. En effet, selon la présente invention et comme on le verra ci-après, il a été noté qu'il était particulièrement avantageux d'émettre comme signaux codés d'une part au moins une impulsion simultanée sur les deux voies de sortie puis une suite d'impulsions codées sur la seule voie qui doit être spécifiquement commandée.

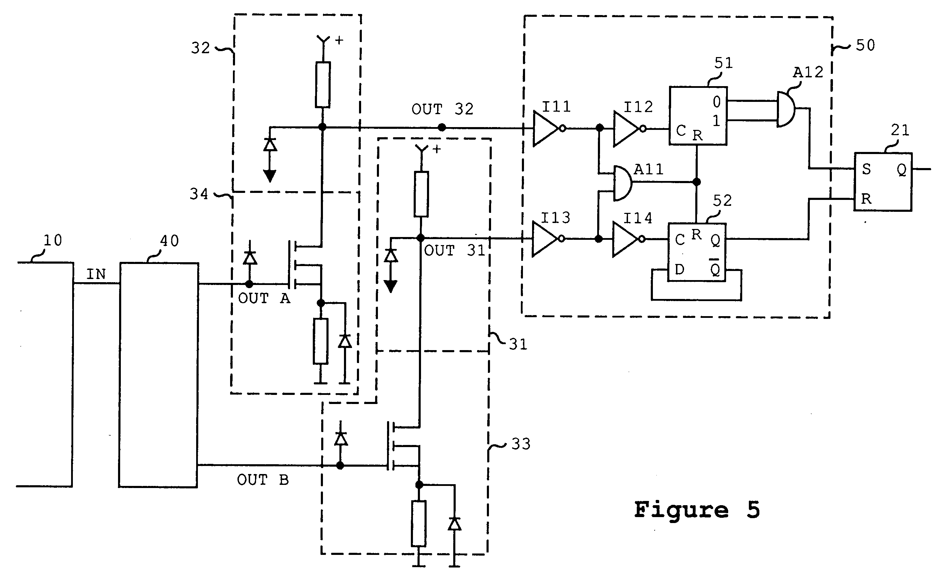

La figure 5 représente un schéma d'ensemble du circuit selon la présente invention dans lequel la partie de décodage a plus particulièrement été détaillée. On y retrouve le circuit de contrôle 10 fournissant un signal d'entrée IN à un codeur 40 muni de sorties OUTA et OUTB. Ces sorties sont envoyées à des translateurs de niveau correspondant aux éléments 31 à 34 de la figure 3. Ces translateurs de niveau envoient des signaux aux entrées S et R d'une bascule 21 par l'intermédiaire d'un circuit de décodage 50.

Les translateurs de niveau 31, 33 et 32, 34 sont des circuits classiques, similaires à ceux qui seraient utilisés dans le cas de la figure 2. Ils ne seront donc pas décrits ici en détail. Leurs sorties sont désignées par les références OUT31 et OUT32. En l'absence de parasites, les signaux sur les sorties OUT32 et OUT31 correspondent respectivement aux signaux de sortie OUTA et OUTB du codeur 40.

Dans la figure, on a représenté par des triangles noirs à pointe tournée vers le bas les points connectés à la masse flottante V_{F}.

Le décodeur 50 reçoit sur ses deux entrées les signaux OUT32 et OUT31. Le signal OUT32 est envoyé par l'intermédiaire de deux inverseurs successifs I11 et I12 à l'entrée C d'un compteur 51 et le signal OUT31 est envoyé par l'intermédiaire de deux inverseurs successifs I13 et I14 à l'entrée C d'une bascule de type D 52. Le point de raccordement des inverseurs I11 et I12 est connecté à la première entrée d'une porte ET A11 dont la deuxième entrée est connectée au point de raccordement des inverseurs I13 et I14 et dont la sortie est connectée aux bornes de remise à zéro R du compteur 51 et de la bascule 52. Les deux sorties 0 et 1 du compteur 51 sont envoyées à deux entrées d'une porte ET A12 dont la sortie est reliée à l'entrée S de la bascule 21. La sortie Q de la bascule 52 est envoyée à l'entrée R de la bascule RS 21. La sortie Q* de la bascule 52 est envoyée à son entrée D.

Le fonctionnement de ce circuit est le suivant. On retrouve en sortie des inverseurs I12 et I14 les signaux OUTA et OUTB, respectivement. La porte ET A11 transmet la première impulsion qui est identique dans OUTA et OUTB et remet à 0 le compteur 51 et la bascule 52. Ensuite :
- dans le cas d'une commande de mise en conduction, le signal à la sortie de l'inverseur I12 présente une succession de passages à 0 (impulsions) tandis que le signal à la sortie de l'inverseur I14 reste à niveau haut. Il en résulte que le compteur 51 fournit des sorties hautes simultanées après le comptage d'un certain nombre d'impulsions (ici 3) et qu'alors la porte ET A12 commande l'entrée S de la bascule 21 dont la sortie Q passe alors à haut niveau,
- dans le cas d'une commande d'ouverture, c'est l'inverseur I14 qui fournit une suite d'impulsions à l'entrée d'horloge de la bascule 52 et, dès la première impulsion non-simultanée à une impulsion sur l'autre voie, la sortie Q de cette bascule passe à haut niveau et remet à zéro la bascule 21.

On notera que des parsasites sur la masse flottante V_{F}, résultant par exemple de gradients de tension très importants entraînant l'apparition d'impulsions simultanées aux sorties OUT32 et OUT31 des translateurs de niveau. Grâce au choix du système de codage selon l'invention, prévoyant avant tout envoi de signaux d'informations des impulsions simultanées de remis à zéro du décodeur, de tels parasites seront sans effet sur le fonctionnement du circuit.

Selon un autre avantage de la présente invention, le signal de fermeture résultant de la sortie du compteur 51 envoyée à l'entrée S de la bascule 21 est retardé tandis que le signal d'ouverture résultant de la sortie Q de la bascule 52 est envoyé sur l'entrée R de la bascule 21 et transmis immédiatement. Il est donc fourni de façon inhérente un léger retard entre un ordre de fermeture et un ordre d'ouverture, ce retard étant ajustable avec la fréquence de l'oscillation du codeur 40. Etant donné que, comme on l'a exposé précédemment, un circuit selon la présente invention est destiné à être inséré dans un circuit de commande de pont, ceci évite des situations où deux commutateurs de puissance d'un pont seraient fermés simultanémement ce qui provoquerait des risques de court-circuit d'un bras du pont.

Alors que l'on a décrit ici un codeur du côté des circuits référencés à la masse et un décodeur du côté des circuits référencés au potentiel flottant, chacun de ces éléments pourrait être remplacé par un codeur/décodeur pour permettre le renvoi à partir d'un commutateur de puissance flottant d'informations sur son état de fonctionnement.

## Revendications

1. Circuit de commande et de contrôle d'un commutateur de plissanoe comprenant une première partie (20) liée à ce commutateur et alimentée en référence au potentiel flottant (V_{F}) d'une électrode de ce commutateur, une deuxième partie (10) liée à des circuits extérieurs au commutateur et alimentée en référence à un potentiel fixe, un codeur (40) au niveau de la deuxième partie, et un décodeur (50) adapté au niveau de la première partie, la liaison entre les deux parties se faisant par deux voies, ces deux voies étant respectivement reliées aux entrées R et S d'une bascule (21) reliée aux sorties du décodeur (50), caractérisé en ce que le codeur comprend des moyens pour envoyer simultanément au moins une impulsion sur chaque voie puis au moins une impulsion sur une voie sélectionnée, le décodeur comprenant des moyens de décodage appropriés.

2. Circuit de commande et de contrôle selon la revendication 1, caractérisé en ce que les première et deuxième parties comprennent chacune un codeur/décodeur.

## Patentansprüche

1. Steuer- und Überwachungsschaltung für einen Leistungsschalter, mit einem ersten Abschnitt (20), der mit diesem Schalter verbunden ist und der bezüglich einer Schwebespannung (V_{F}) einer Elektrode dieses Schalters gespeist wird, einem zweiten Abschnitt (10), der mit externen Schaltungen mit dem Schalter verbunden ist und bezüglich einer festen Spannung gespeist wird, einem Codierer (40) der auf der Seite des zweiten Abschnittes angeordnet ist, und einem passenden Decodierer (50), der auf der Seite des ersten Abschnitts angeordnet ist, wobei die Verbindung zwischen den beiden Abschnitten über zwei Pfade gebildet wird, welche jeweils mit Eingängen R und S eines Flip-Flops (21) verbunden sind, das mit dem Ausgang des Decodierers (50) verbunden ist, dadurch **gekennzeichnet**, daß der Codierer eine Vorrichtung zum gleichzeitigen Senden mindestens eines Impulses auf jeden Pfad und dann mindestens eines Impulses auf einen ausgewählten Pfad aufweist, wobei der Decodierer geeignete Decodierungsmittel aufweist.

2. Steuer- und Überwachungsschaltung nach Anspruch 1, dadurch **gekennzeichnet**, daß der erste und der zweite Abschnitt jeweils einen Codierer/Decodierer aufweisen.

## Claims

1. A control and monitoring circuit for a power switch comprising a first portion (20) connected to this switch and fed with reference to a floating voltage (V_{F}) of an electrode of this switch, a second portion (10) connected to circuits external to the switch and fed with reference to a fixed voltage, a coder (40) arranged on the side of the second portion and a suitable decoder (50) arranged on the side of the first portion, the connection between said two portions being made by two paths respectively connected to the inputs R and S of a flip-flop (21) connected to the outputs of said decoder (50), characterized in that said coder comprises means for simultaneously sending at least one pulse on each path, then at least one pulse on a selected path, the decoder comprising suitable decoding means.

2. A control and monitoring circuit for a power switch according to claim 1, characterized in that said first and second portions each comprise a coder/decoder.
